# EUROPÄISCHE PATENTANMELDUNG

(11) **EP 0 848 261 A2**
(43) Veröffentlichungstag der Anmeldung: **17.06.1998**
(21) Anmeldenummer: 97121606.4
(22) Anmeldetag: 08.12.1997
(51) Int. Cl.: G01R 33/028

(54) **Sonde zur Erfassung von magnetischen Wechselfeldern**

(30) Priorität: 13.12.1996 DE 19651923
(71) Anmelder: STN ATLAS Elektronik GmbH, D-28305 Bremen (DE)
(72) Erfinder: Bornhöfft, Wolfgang, 21220 Seevetal (DE); Trenkler, Gerhard, 22885 Barsbüttel (DE)

(57) **Zusammenfassung**

Eine Sonde zur Erfassung von magnetischen Wechselfeldern weist einen hochpermeablen Sondenkern (10) und eine diesen umgebenden Meßwicklung auf, die aus mehreren, in Reihe geschalteten Spulen zuammengesetzt ist. Zwecks Schaffung einer Sonde, die geeignet ist für die Erfassung extrem niederfrequenter, magnetischer Wechselfelder aus einer Mindestdistanz, die üblicherweise für die Detektion von solche Wechselfelder erzeugenden Schwimmkörpern gefordert wird, ist der Sondenkern (10) aus flachen Streifen (16) aus amorphem oder mikrokristallinem, magnetisierbarem Material mit dazwischenliegenden Isolationsstreifen (17) zusammengesetzt. Die Spulen der Meßwicklung sind als selbsttragende Spulen, vorzugsweise als Backlackdrahtspulen, ausgebildet und umschließen den Sondenkern (10) nahezu abstandslos.

## Beschreibung

Die Erfindung betrifft eine Sonde zur Erfassung von magnetischen Wechselfeldern der im Oberbegriff des Anspruchs 1 definierten Gattung.

Bei einer bekannten Sonde dieser Art (DE 26 25 964 C3) besteht der Sondenkern aus Mumetalldrähten von maximal 2 mm Durchmesser, die gebündelt in einem Mantelrohr vergossen sind. Als Mantelrohr dient ein geschlitztes, dünnwandiges Messingrohr. Die Meßwicklung ist aus Kupfer gewickelt und auf drei Spulen verteilt. Jede Spule ist auf einen Spulenkörper aufgewickelt, der zur Verringerung der Wicklungskapazität in drei Kammern unterteilt ist, die jeweils mit der Kupferwicklung ausgefüllt sind. Zwischen den einzelnen Spulen sind kurze Abstände freigelassen, in die Tragstege zur Halterung des Sondenkern eingreifen. Die Tragstege stützen sich ihrerseits auf eine Tragplatte, z.B. einem U-förmigen Aluminiumprofil, ab.

Solche Sonden mit einem aus Mumetalldrähten aufgebauten Sondenkern sind nicht ausreichend empfindlich, um zu Detektionszwecken auch extrem niederfrequente, magnetische Wechselfelder, wie sie von Schwimmkörpern, z.B. U-Booten mit elektrischen Antriebseinrichtungen und elektronischen Datenverarbeitungsanlagen, im Wasser erzeugt werden, in ausreichend großer Distanz von einigen hundert Metern zum Schwimmkörper erfassen zu können. Dies liegt in erster Linie darin begründet, daß die für diesen Anwendungsfall erforderlichen magnetischen Eigenschaften des Sondenkerns nicht erreicht werden können, da die Mumetalldrähte durch das Aufrollen und Abwickeln sowie das mechanische Ausrichten bei der Fertigung des Sondenkerns ihre magnetische Eigenschaft zu einem großen Teil verlieren. Abhilfe könnte dadurch geschaffen werden, daß nach dem Einfüllen dieser Mumetalldrähte in das Mantelrohr ein Glühvorgang durchgeführt würde. Ein solcher Glühvorgang zerstört aber die üblicherweise bei diesen Mumetalldrähten vorhandene Lackisolierung, wodurch elektrische Verbindungen entstehen, die den Wirbelstromeinfluß auf den Sondenkern soweit vergrößern, daß sich die Sonde nicht mehr linear verhält. Möglich wäre eine hochglühfähige Isolierung der Mumetalldrähte, was jedoch ein so hochkomplexes Herstellungsverfahren erfordert, daß die Fertigungskosten für die Sonde nicht mehr tragbar sind.

Der Erfindung liegt die Aufgabe zugrunde, eine Sonde der eingangs genannten Art für die Erfassung niederfrequenter, magnetischer Wechselfelder im Wasser aus einer Mindestdistanz, die üblicherweise für die Detektion von Schwimmkörpern, die solche Wechselfelder abstrahlen, gefordert wird, zu optimieren und dabei auf eine einfache, kostensparende Fertigung zu achten.

Die Aufgabe ist bei einer Sonde der im Oberbegriff des Anspruchs 1 angegebenen Gattung erfindungsgemäß durch die Merkmale im Kennzeichenteil des Anspruchs 1 gelöst.

Die erfindungsgemäße Sonde hat den Vorteil, daß das zum Aufbau des Sondenkerns verwendete Bandmaterial aus amorphem oder kristallinem Material, z.B. VITROVAC C 6025 der Vacuumschmelze Hanau, seine magnetischen Eigenschaften bei mechanischer Beanspruchung und Bearbeitung nicht verliert, so daß der Wickelvorgang zur Herstellung des Sondenkerns im Gegensatz zu den Sonden mit Mumetall dessen magnetische Eigenschaft nicht beeinträchtigt. Die zwischen den hochpermeablen sog. Kernstreifen einliegenden Isolationsstreifen verhindern einen direkten elektrischen Kontakt zwischen den Kernstreifen und unterdrücken damit die Ausbildung von Wirbelströmen innerhalb des Sondenkerns, die das zu messende Magnetfeld erheblich schwächen würden. Durch Ausbildung der Spulen der Meßwicklung als selbsttragende Spulen, z.B. in Backlacktechnik, kann auf einen Spulenkörper verzichtet und die Spulen unmittelbar mit nur durch Toleranzen bedingten Minimalabstand auf den Sondenkern aufgeschoben werden, was ebenfalls zu einer Verbesserung der magnetischen Meßeigenschaften der Sonde beiträgt.

Das Fertigungsverfahren für die Sonde ist einfach und läßt geringe Fertigungskosten erwarten, insbesondere, wenn gemäß einer bevorzugten Ausführungsform der Erfindung das hochpermeable Sondenmaterial in einen im Querschnitt U-förmigen Kernträger aus Kunststoff oder Metall eingelegt wird. Beim Herstellungsverfahren der Sonde werden zwei solche U-förmigen Kernträger mit ihrem Jochteil aneinandergelegt und das Bandmaterial aus amorphem Material mittels einer besonderen Wickelvorrichtung in Längsrichtung in die beiden Kernträger eingewickelt, wobei zwischen jeder Wickellage der Isolationsstreifen als extrem dünne streifenförmige Isolierfolie, z.B. aus Hostaphan, angeordnet wird. In einem bevorzugten Ausführungsbeispiel der Erfindung weist das Bandmaterial aus amorphem Material eine Stärke von ca. 20 µm und eine Breite von ca. 5 mm und die Isolierfolie eine Stärke von 6 µm und eine Breite von ca. 6 mm auf. Anstelle eines einzigen hochpermeablen Kernstreifens können in jeder Wickellage mehrere schmalere Streifen von ca. 2,2 mm Breite parallelgewickelt werden, wobei zwischen ihnen ein Abstand verbleibt, um eine gegenseitige Berührung zu vermeiden. Nach Verschließen der U-förmigen Kernträger mit jeweils einem elektrisch leitfähigen Deckel, der vorzugsweise an dem Kernträger verklebt wird, werden die beim Wickelvorgang entstehenden beiden Wickelköpfe an den beiden Kernträgerenden aufgeschnitten und die Sondenkerne mit Kunststoff unter Vakuum getränkt, wobei verbleibende Hohlräume gefüllt werden. Hat der Sondenkern seine endgültige mechanische Stabilität erreicht, so wird er durch mechanische Bearbeitung auf seine gewünschte Länge gebracht.

Zweckmäßige Ausführungsformen der erfindungsgemäßen Sonde mit vorteilhaften Weiterbildungen und Ausgestaltungen der Erfindung ergeben sich aus den weiteren Ansprüchen.

In einer bevorzugten Ausführungsform der Erfindung werden die Spulen der Meßwicklung aus einem großen Fertigungslos von Spulen in Hinblick auf größtmögliche Übereinstimmung ihrer Wicklungskapazitäten, Induktivitäten und Resonanzfrequenzen ausgesucht und zur Meßwicklung zusammengestellt. Hierdurch wird eine wesentliche Verbesserung der Amplituden- und Phasentreue im Nutzfrequenzbereich im Vergleich zu der bekannten Sonde erreicht, bei der die Spulen in mehrkammerige Spulenkörper eingewickelt werden. Die Toleranz der Phasenlage im Nutzfrequenzbereich kann damit weit unter 2 % gehalten werden, die etwa bei der bekannten Sonde erreicht wird.

Gemäß einer vorteilhaften Ausführungsform der Erfindung ist der mit dem Kern- und den Isolationsstreifen gefüllte U-förmige Kernträger von einem elektrisch leitfähigen Deckel abgedeckt, der aus einem elektrisch leitenden Blech, vorzugsweise aus einer Isolierplatte oder einem Isoliergewebe (Glasgewebe) mit aufkaschierter Leiterbahn besteht. Die vorzugsweise aus Kupfer bestehende Leiterbahn ist mit einem elektrischen Anschluß versehen, über den ein Spannungspotential angelegt werden kann. Das Spannungspotential wird dabei so bemessen, daß die zwischen Meßwicklung und Sondenkern sich ausbildende Kapazität minimiert wird.

Eine verfeinerte Anpaßmöglichkeit für diese Einstellung der Kapazität zwischen Meßwicklung und Sondenkern ergibt sich, wenn gemäß einer weiteren Ausführungsform der Erfindung die Leiterbahnen des Deckels in eine der Anzahl der Spulen entsprechende Zahl von Leiterbahnabschnitten unterteilt wird, was bei einer Kupfer-Leiterbahn in einfacher Weise durch Ätzen der Kupferfläche erreicht wird. Jeder einzelne Leiterbahnabschnitt wird dann mit einem elektrischen Anschluß versehen. Über diese elektrischen Anschlüsse werden die Leiterbahnabschnitte auf unterschiedliche Spannungspotentiale derart eingestellt, daß die resultierende Kapazität zwischen Sondenkern und Meßwicklung minimiert wird. Die Potentialeinstellung läßt sich auch mit einem integrierten Widerstandsteilen erreichen, der bevorzugt aus SMD(surface mounted device)-Widerständen besteht, die zwischen die elektrischen Anschlüsse gelegt werden.

Gemäß einer weiteren Ausführungsform der Erfindung wird der Sondenkern mit einer elektrisch leitfähigen Folie umschlossen, die sich von der Leiterbahn aus über den Kernträger bis zurück zur Leiterbahn erstreckt und einerseits mit dieser längs ihrer einen Endkante elektrisch leitend verbunden ist und andererseits gegenüber dieser elektrisch isoliert ist. Die elektrisch leitfähige Folie ist ebenfalls mit einem elektrischen Anschluß versehen, über die ein Spannungspotential zur Reduzierung der sich zwischen Meßwicklung und dem Sondenkern ausbildenden elektrischen Kapazität belegt ist.

Gemäß einer bevorzugten Ausführungsform der Erfindung wird auch hier die elektrisch leitfähige Folie in einer der Anzahl der Spulen der Meßwicklung entsprechende Zahl von elektrisch voneinander getrennten, jeweils einen elektrischen Anschluß aufweisenden Folienabschnitten unterteilt. Über die elektrischen Anschlüsse werden unterschiedliche Spannungspotentiale an die Folienabschnitte gelegt, die so dimensioniert sind, daß die resultierende Kapazität zwischen der Meßwicklung und dem Sondenkern ein Minimum annimmt. Die Spannungspotentiale zwischen den Folienabschnitten können auch mittels eines integrierten Widerstandsteilers generiert werden, wobei die einzelnen elektrischen Anschlüsse der Folienabschnitte über entsprechend bemessene Widerstände miteinander verbunden und an ein Spannungspotential gelegt sind.

Gemäß einer bevorzugten Ausführungsform der Erfindung ist der Sondenkern mit Meßwicklung und Potentialflächen in ein Gehäuse aus elektrisch leitfähigem Material eingelegt, wobei bevorzugt dessen Gehäusewanddicke so bemessen wird, daß die aufgrund von Wirbelstromeffekten gegebene obere Grenzfrequenz der Sonde zwischen 20 Hz und 100 Hz liegt. Durch ein solches Gehäuse wird der Einfluß externer Störungen auf das Meßergebnis der Sonde weitgehend unterdrückt. Dabei ist es vorteilhaft, gemäß einer weiteren Ausführungsform der Erfindung den für den Sondenkern unerläßlichen Anpaßverstärker und die Stromversorgung mit in das Gehäuse zu integrieren, so daß auch externe Störeinflüsse, die zwischen Sonde und Verstärker einkoppeln könnten, weitgehend unterdrückt werden. Der Verstärker ist dabei so zu dimensionieren, daß er nur eine vernachlässigbar kleine elektrische Belastung für die Sonde darstellt.

Gemäß einer weiteren Ausführungsform der Erfindung ist im Abstand um die Meßwicklung herum eine aus einem elektrisch leitfähigen Blech oder einer elektrisch leitfähigen Folie bestehende, umlaufende Potentialfläche gelegt, deren aneinanderstoßenden Längsendkanten gegeneinander elektrisch isoliert sind. Die Potentialfläche ist mit elektrischen Anschlüssen zum Anlegen eines Spannungspotentials versehen, das so eingestellt wird, daß die sich zwischen der Meßwicklung und dem Gehäuse ausbildende Kapazität minimiert wird. Alternativ kann die Potentialfläche auch an den elektrisch leitenden Deckel des Sondenkerns angeschlossen werden, so daß sie auf dem gleichen Potential wie der Sondenkern liegt.

Gemäß einer bevorzugten Ausführungsform der Erfindung ist die um die Meßwicklung herumgeführte mantelartige Potentialfläche quer zu ihrer Achse in eine der Anzahl der Spulen entsprechende Zahl von ringförmigen Potentialflächenabschnitten unterteilt, die elektrisch voneinander getrennt sind und elektrische Anschlüsse aufweisen, über die sie auf unterschiedliche Spannungspotentiale eingestellt sind. Die unterschiedliche Spannungspotentiale können auch durch einen integrierten Spannungsteiler herbeigeführt werden, dessen Widerstände zwischen den elektrischen Anschlüssen der Potentialflächenabschnitte eingeschaltet sind. Die einzelnen Spannungspotentiale werden auch hier so bemessen, daß die resultierende Kapazität zwischen der Meßwicklung und dem Gehäuse minimiert wird, was um so besser erreicht wird, je weiter sich die elektrischen Spannungen zwischen den Spulen und dem Gehäuse zu Null hin verkleinern.

Gemäß einer weiteren Ausführungsform der Erfindung ist zwischen benachbarten Spulen der Meßwicklung jeweils eine von diesen beabstandete, rechtwinklig zu den Spulenachsen sich erstreckende, ebene Potentialfläche angeordnet, die aus einem elektrisch leitfähigen Blech oder einer elektrisch leitfähigen Folie besteht und mit elektrischen Anschlüssen versehen ist. Mit diesen Potentialflächen können die zwischen den einzelnen Spulen der Meßwicklung sich ausbildenden Kapazitäten in Richtung auf eine Minimierung beeinflußt werden, wozu geeignete Spannungspotentiale an die elektrischen Anschlüsse der Potentialflächen gelegt werden. Die unterschiedlichen Potentiale können entweder mit einem entsprechenden Netzwerk eingestellt oder über einen Widerstandsteiler realisiert werden, dessen Widerstände zwischen den einzelnen Anschlüssen der Potentialflächen geschaltet sind. Die Anschlüsse der Potentialflächen können aber auch miteinander verbunden und an ein gemeinsames Spannungspotential angeschlossen werden.

Mit der gezielten Reduzierung der sich unvermeidlich ausbildenden Kapazitäten einerseits zwischen Sondenkern und Meßwicklung, andererseits zwischen Meßwicklung und Gehäuse und außerdem zwischen den Spulen der Meßwicklung wird erreicht, daß die Resonanzfrequenz der Sonde beträchtlich erhöht wird und damit weit oberhalb des Nutzfrequenzbereichs der Sonde liegt, der bei Verwendung der Sonde für Ortungsaufgaben von magnetische Wechselfelder abstrahlenden Schwimmkörpern bei <300 Hz liegt. Dieser große Abstand zwischen maximaler Nutzfrequenz und Resonanzfrequenz ist zur Minimierung von Amplituden- und Phasenfehlern von wesentlichem Vorteil.

Die Erfindung ist anhand eines in der Zeichnung dargestellten Ausführungsbeispiels im folgenden näher beschrieben. Es zeigen jeweils in schematischer Darstellung:
- Fig. 1: eine Sonde zur Erfassung niederfrequenter magnetischer Wechselfelder im Wasser, in perspektivischer Explosionsdarstellung,
- Fig. 2: eine perspektivische Darstellung eines Sondenkerns der Sonde in Fig. 1,
- Fig. 3: eine perspektivische Darstellung eines Deckels des Sondenkerns in Fig. 2,
- Fig. 4: eine perspektivische Darstellung des mit einer Potentialfläche umhüllten Sondenkerns in Fig. 2,
- Fig. 5: einen Schnitt längs der Schnittfläche V-V in Fig. 4,
- Fig. 6: eine perspektivische Darstellung der Meßwicklung der Sonde in Fig. 1 mit ringförmigen Potentialflächenabschnitten und ebenen Potentialflächen.

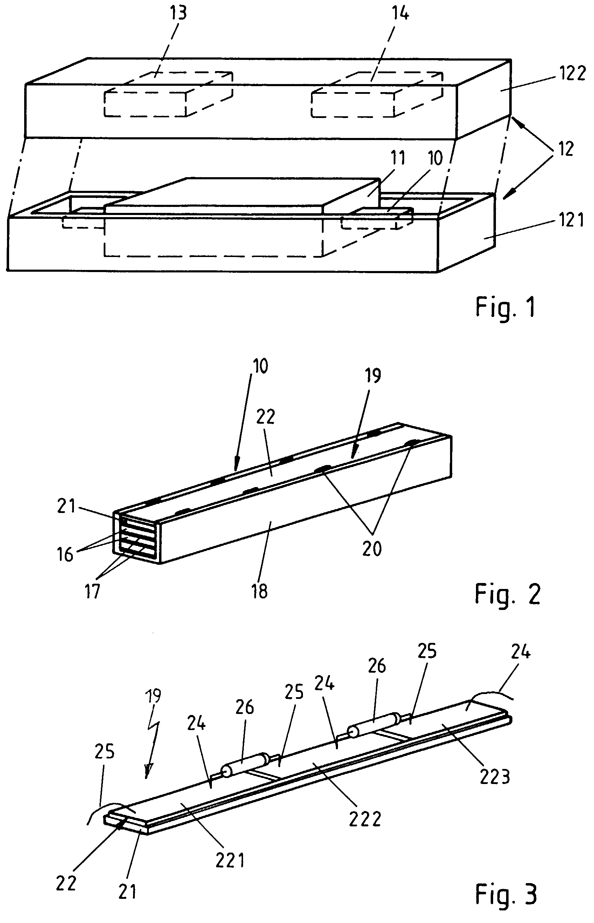

Die in Fig. 1 schematisch in perspektivischer Explosionszeichnung dargestellte Sonde zur Erfassung von niederfrequenten, magnetischen Wechselfeldern, wie sie von Schwimmkörpern, z.B. U-Booten mit elektrischen Antriebseinrichtungen und elektronischen Datenverarbeitungsanlagen, im Wasser erzeugt werden, weist einen hochpermeablen Sondenkern 10, eine auf den Sondenkern 10 aufgeschobene Meßwicklung 11 und ein den Sondenkern 10 mit Meßwicklung 11 aufnehmendes Gehäuse 12 auf. Das Gehäuse 12 ist zweiteilig und besteht aus einer Unterschale 121 und aus einer Oberschale 122, die mit einer umlaufenden Stirnfläche aufeinanderliegen und miteinander wasserdicht verklebt sind. In dem Gehäuse 12 ist noch ein Anpaßverstärker 13 und eine Stromversorgung 14 zum Betreiben der Sonde integriert. Der Anpaßverstärker 13 ist so dimensioniert, daß er nur eine vernachlässigbar kleine elektrische Belastung für die Sonde darstellt. Das Gehäuse 12 besteht aus elektrisch leitfähigem Material, und die Gehäusewanddicke ist so bemessen, daß die aufgrund von Wirbelstromeffekten gegebene obere Grenzfrequenz der Sonde zwischen 20 Hz und 100 Hz liegt.

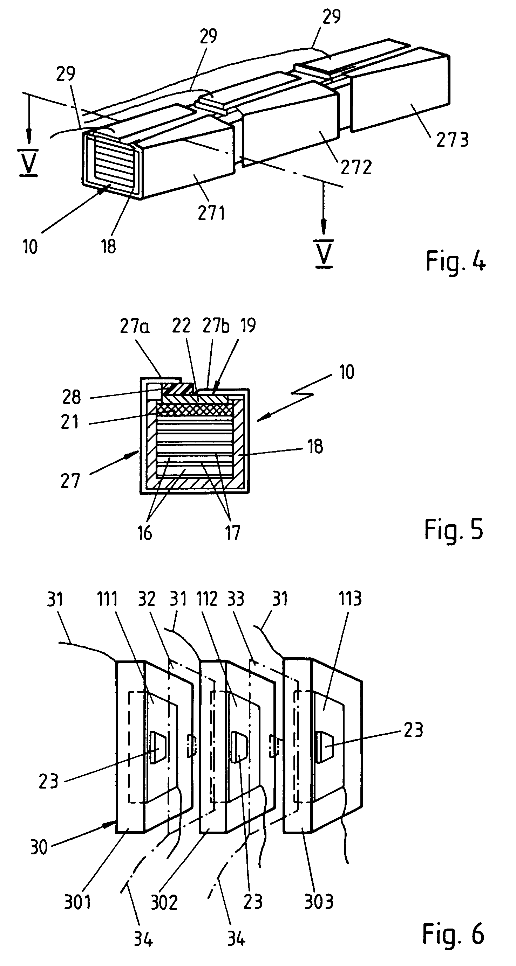

Der hochpermeable Sondenkern 10 ist in Fig. 2 perspektivisch dargestellt. Er ist aus einer Vielzahl von flachen Streifen aus amorphem oder mikrokristallinem, magnetisierbarem Material, im folgenden Kernstreifen 16 genannt, mit dazwischenliegenden Isolationsstreifen 17 zusammengesetzt. Als Material wird z.B. VITROVAC 6025 der Vacuumschmelze Hanau verwendet. Die Isolationsstreifen 17 sind aus einer extrem dünnen Isolierfolie, z.B. aus Hostaphan, so zugeschnitten, daß sie die Kernstreifen 16 mit Überstand überdecken. In einem bevorzugten Ausführungsbeispiel haben die Kernstreifen eine Stärke von 20 µm und eine Breite von ca. 5 mm und die Isolationsstreifen 17 eine Stärke von 6 µm und eine Breite von 6 mm. Anstelle eines einzigen breiten Kernstreifens 16 können in jeder Lage auch mehrere schmalere Einzelstreifen, z.B. von einer Breite von 2,2 mm, parallel nebeneinanderliegen, wobei zwischen diesen ein Abstand verbleibt, so daß sie sich nicht berühren. Will man die effektive Permeabilität des Sondenkerns 10 gezielt einstellen, so wird für die übereinanderliegenden, durch je einen Isolationsstreifen 17 getrennten Kernstreifen 16 Material mit unterschiedlicher Permeabilität verwendet. Zusätzlich können auch die schmalen Einzelstreifen in jeder Lage noch unterschiedliche Permeabilität aufweisen. Die mit der Breite von 6 mm etwas breiter als die Kernstreifen 16 zugeschnittenen Isolationsstreifen 17 stellen sicher, daß ein direkter elektrischer Kontakt zwischen den einzelnen hochpermeablen Kernstreifen 16 auch längs der Ränder zuverlässig verhindert wird. Zur Herstellung des Sondenkerns 10 wird eine besondere Wickelvorrichtung verwendet, welche die als Bandmaterial vorliegenden Kernstreifen 16 mit den dazwischenliegenden, ebenfalls als Bandmaterial vorhandenen Isolationsstreifen 17 in einen im Querschnitt U-förmigen, rechteckigen oder quadratischen Kernträger 18 einwickelt. Nach Füllung des Kernträgers 18 wird dieser mit einem elektrisch leitfähigen Deckel 19 verschlossen, der mit dem Kernträger 18 verklebt wird. Die Klebestellen sind in Fig. 2 mit 20 angedeutet. Der elektrisch leitfähige Deckel 19 besteht bevorzugt aus einer Basisplatte 25, die eine Epoxid-Leiterkarte sein kann, auf die eine Leiterbahn 22, vorzugsweise eine Kupferleiterbahn, aufkaschiert ist (vgl. Fig. 3 und Fig 5). Der so aufgebaute Sondenkern 10 wird mit einem Kunstharz unter Vakuum getränkt, wobei verbleibende Hohlräume gefüllt werden, und anschließend durch mechanische Bearbeitung auf die gewünschte Endlänge gebracht.

Die Meßwicklung 11 besteht aus mehreren einzelnen Spulen, hier drei Spulen 111, 112 und 113, die jeweils als selbsttragende Spulen, z.B. aus Backlackdraht, ausgebildet und elektrisch in Reihe geschaltet sind (Fig. 6). Die Spulen 111, 112 und 113 weisen einen rechteckförmigen Querschnitt auf und sind unter Einhaltung eines gegenseitigen Abstandes unmittelbar auf den Sondenkern 10 aufgeschoben, wobei sie so gewickelt sind, daß sie den Sondenkern 10 weitgehend abstandslos umschließen. Die zentrale lichte Öffnung der Spulen 111 bis 113 zum Durchschieben des Sondenkerns 10, die je nach Ausbildung des Sondenkerns einen quadratischen oder rechteckförmigen Querschnitt aufweist, ist in Fig. 6 mit 23 angedeutet. Die Spulen 111 bis 113 der Meßwicklung 11 werden aus einem größeren Fertigungslos von Einzelspulen bezüglich der Übereinstimmung mindestens einer ihrer Größen, Wicklungskapazität, Induktivität und Resonanzfrequenz ausgesucht. Bevorzugt werden solche Spulen 111 bis 113 zu der Meßwicklung 11 zusammengestellt, die in allen drei Größen am weitesten übereinstimmen.

Entsprechend der Aufteilung der Meßwicklung 11 auf drei selbsttragende Spulen 111 bis 113 ist die Leiterbahn 22 auf der Basisplatte 21 des Deckels 19 in drei Leiterbahnenabschnitte 221, 222 und 223 unterteilt, was beispielsweise durch Ätzen der Kupferschicht erfolgen kann. Jeder Leiterbahnabschnitt 221 bis 223 kann über Anschlußleitungen 24, 25 extern angeschlossen werden, um den Einfluß der zwischen Sondenkern 10 und der Meßwicklung 11 sich ausbildenden Kapazitäten durch Steuerung des elektrischen Potentials der Leiterbahnabschnitte 221 bis 223 zu reduzieren, vorzugsweise zu eliminieren. Im Ausführungsbeispiel der Fig. 3 werden die unterschiedlichen Spannungspotentiale an den Leiterbahnabschnitten 221 bis 223 mittels eines Widerstandsteilers aus SMD-Widerständen 26 realisiert, die zwischen den elektrischen Anschlüsse 24 und 25 der benachbarten Leiterbahnabschnitte 221 bis 223 eingeschaltet sind. Die beiden elektrischen Anschlüsse 24 und 25 der beiden äußeren Leiterbahnabschnitte 221 und 223 sind an ein externes Spannungspotential gelegt.

Eine verbesserte Reduzierung der sich zwischen der Meßwicklung 11 und dem Sondenkern 10 ausbildenden Kapazität kann erreicht werden, wenn der Sondenkern 10 von einer elektrisch leitfähigen Folie 27 umschlossen ist, wie dies in Fig. 5 dargestellt ist. Die Folie 27 erstreckt sich dabei ausgehend von der Leiterbahn 22 des Deckels 19 über den gesamten Kernträger 18 bis wieder zurück zur Leiterbahn 22. Damit sie keinen geschlossenen Strompfad bildet, ist der eine Längsendabschnitt 27a der Folie 27 gegenüber der Leiterbahn 22 mittels eines Isolierstreifens 28 isoliert. Der gleiche Effekt kann unter Verzicht auf den Isolierstreifen 28 auch dadurch erreicht werden, daß die Leiterbahn 22 längsgeschlitzt ist, wonach die beiden Längsendabschnitte 27a, 27b der Folie 27 mit der geschlitzten Leiterbahn 22 beidseitig des Längsschlitzes elektrisch leitend, z.B. durch Lötung, verbunden werden können. Bei Verwendung des Isolierstreifens 28 gegenüber der Leiterbahn 22 ohne Längsschlitz ist nur der Längsendabschnitt 27b der Folie 27 mit der Leiterbahn 22 verlötet.

Entsprechend der Aufteilung der Meßwicklung 11 in drei Spulen 111 bis 113 ist es zweckmäßig, die elektrisch leitfähige Folie 27 in drei einzelne, voneinander beabstandete Folienabschnitte 271, 272 und 273 zu unterteilen, wie dies in Fig. 4 dargestellt ist. Jeder Folienabschnitt 271 bis 273 ist dabei mit einem elektrischen Anschluß 29 versehen. Über die Anschlüsse 29 können wiederum die Folienabschnitte 271 bis 273 mit unterschiedlichen elektrischen Potentialen belegt werden. Das elektrische Potential der einzelnen Folienabschnitte 271 bis 273 wird dabei so bemessen, daß die resultierende Kapazität zwischen Sondenkern 10 und Meßwicklung 11 minimal wird. Auch diese Potentialunterschiede können wiederum mit einem integrierten Widerstandsteiler herbeigeführt werden, wie er zu Fig. 3 beschrieben worden ist.

Wie in Fig. 6 schematisch dargestellt ist, ist um die Meßwicklung 11 herum im Abstand davon eine aus einem elektrisch leitfähigen Blech oder aus einer elektrisch leitfähigen Folie bestehende mantelartig umlaufende Potentialfläche gelegt, die entsprechend der Unterteilung der Meßwicklung in drei ringförmige Potentialflächenabschnitte 301, 302 und 303 unterteilt ist, wobei jeweils ein Potentialflächenabschnitt 301 bzw. 302 bzw. 303 eine Spule 111 bzw. 112 bzw. 113 mit Abstand umschließt. Um einen geschlossenen Strompfad innerhalb der Potentialflächenabschnitte 301 bis 303 zu vermeiden, sind zumindest die bei der Ringbildung aneinanderstoßenden, in Achsrichtung sich erstreckenden Enden der Potentialflächenabschnitte 301 bis 303 gegeneinander elektrisch isoliert. Das gleiche wird auch durch eine Schlitzung der Potentialflächenabschnitte parallel zur Achse der Meßwicklung 11 erreicht. Jeder Potentialflächenabschnitt 301 bis 303 ist mit einem elektrischen Anschluß 31 versehen. Diese Potentialflächenabschnitte 301 bis 303 dienen dazu, den Einfluß der zwischen der Meßwicklung 11 und dem Gehäuse 12 sich ausbildenden Kapazitäten weitgehend zu reduzieren. Hierzu werden wiederum über die elektrischen Anschlüsse 31 entsprechende elektrische Potentiale an die Potentialflächenabschnitte 301 bis 303 gelegt. Die Potentialsteuerung kann dabei über ein integriertes Netzwerk oder einen integrierten Widerstandsteiler erfolgen, wie dieser in Fig. 3 dargestellt ist. Es ist auch möglich, alle Potentialflächenabschnitte 301 bis 303 miteinander zu verbinden und an ein gemeinsames elektrisches Potential anzuschließen. In diesem Fall kann aber auch auf eine Unterteilung der Potentialfläche 30 in die Potentialflächenabschnitte 301 bis 303 verzichtet werden, so daß die Potentialfläche 30 die Meßwicklung 11 auf deren vollen Länge umschließt.

Da sich auch zwischen den Spulen 111 bis 113 Kapazitäten ausbilden, die die magnetischen Eigenschaften der Sonde nachteilig beeinflussen, ist zwischen benachbarten Spulen 111 und 112 bzw. 112 und 113 jeweils eine von diesen beabstandete, rechtwinklig zu den Spulenachsen sich erstreckende, ebene Potentialfläche 32 bzw. 33 angeordnet, wie dies in Fig. 6 strichpunktiert angedeutet ist. Jede Potentialfläche 32 bzw. 33 besteht aus einem elektrisch leitfähigem Blech oder einer elektrisch leitfähigen Folie und ist mit einem elektrischen Anschluß 34 versehen. An diese Potentialflächen 32, 33 werden wiederum elektrische Spannungspotentiale angelegt, und zwar in einer solchen Größe, daß die zwischen den Spulen 111 bis 113 sich ausbildenden Kapazitäten minimal sind. Die erforderlichen Spannungspotentiale werden durch integrierte Netzwerke über die Anschlüsse 34 an die Potentialflächen 32, 33 gelegt. Die Verwendung eines integrierten Widerstandsteilers ist ebenso möglich. Die Potentialflächen können aber auch untereinander verbunden sein und an ein gemeinsames Steuerpotential gelegt werden.

## Patentansprüche

1. Sonde zur Erfassung von magnetischen Wechselfeldern, mit einem hochpermeablen Sondenkern (10) und einer diesen umgebenden Meßwicklung (11), die aus mehreren, in Reihe geschalteten Spulen (111 bis 113) zusammengesetzt ist, dadurch gekennzeichnet, daß der vorzugsweise einen rechteckigen Querschnitt aufweisende Sondenkern (10) aus flachen Streifen aus amorphem oder mikrokristallinem, magnetisierbarem Material (Kernstreifen 16) mit dazwischenliegenden Isolationsstreifen (17) zusammengesetzt ist und die Spulen (111 bis 113) als selbsttragende Spulen, vorzugsweise als Backlackdrahtspulen, ausgebildet sind und den Sondenkern (10) nahezu abstandslos umschließen.

2. Sonde nach Anspruch 1, dadurch gekennzeichnet, daß die Isolationsstreifen (17) aus einer extrem dünnen Isolierfolie, z.B. aus Hostaphan, so geschnitten sind, daß sie die Kernstreifen (16) mit Überstand überdecken.

3. Sonde nach Anspruch 2, dadurch gekennzeichnet, daß die Kernstreifen (16) und die Isolationsstreifen (17) als sich abwechselnde Lagen in einen im Querschnitt U-förmigen, rechteckigen oder quadratischen Kernträger (18) eingelegt sind, der mit einem elektrisch leitenden Deckel (19) verschlossen ist, und daß die Spulen (111 bis 113) auf den mit dem Deckel (19) verschlossenen Kernträger (18) unmittelbar aufgeschoben sind.

4. Sonde nach Anspruch 3, dadurch gekennzeichnet, daß die Kernstreifen (16) eines Sondenkerns (10) unterschiedliche Permeabilität aufweisen.

5. Sonde nach Anspruch 3 oder 4, dadurch gekennzeichnet, daß jeder Kernstreifen (16) in mehrere, voneinander längsgetrennte und beabstandete, schmale Einzelstreifen unterteilt ist, die gleiche oder unterschiedliche Permeabilität aufweisen.

6. Sonde nach einem der Ansprüche 3 bis 5, dadurch gekennzeichnet, daß der elektrisch leitende Deckel (19) aus einer Isolierplatte (21) oder einem Isoliergewebe und einer auf deren Oberseite flächig aufkaschierten Leiterbahn (22) besteht und daß die Leiterbahn (22) mit elektrischen Anschlüssen (24, 25) versehen ist.

7. Sonde nach Anspruch 6, dadurch gekennzeichnet, daß der mit Kern- und Isolationsstreifen (16, 17) gefüllte und mit dem Deckel (19) verschlossene Kernträger (18) mit Kunststoff unter Vakuum getränkt ist.

8. Sonde nach Anspruch 6 oder 7, dadurch gekennzeichnet, daß der Sondenkern (10) mit einer elektrisch leitfähigen Folie (27) umschlossen ist, die sich von der Leiterbahn (22) des Deckels (19) aus über den Kernträger (18) bis zurück zur Leiterbahn (22) erstreckt und einerseits mit dieser längs ihres einen Längsendabschnitts (27b) elektrisch leitend verbunden ist und andererseits mit ihrem anderen Längsendabschnitt (27a) gegenüber dieser elektrisch isoliert ist, und daß die elektrisch leitfähige Folie (27) mit elektrischen Anschlüssen (29) versehen ist.

9. Sonde nach Anspruch 8, dadurch gekennzeichnet, daß die elektrisch leitfähige Folie (27) mit der Leiterbahn (22) des Deckels (19) elektrisch leitend verbunden ist.

10. Sonde nach Anspruch 8 oder 9, dadurch gekennzeichnet, daß die elektrische Isolation durch einen zwischen der Leiterbahn (22) und dem Längsendabschnitt (27a) der Folie (27) angeordneten Isolierstreifen (28) oder durch Längsschlitzung der elektrischen Leiterbahn (22) bewirkt ist.

11. Sonde nach einem der Ansprüche 6 bis 10, dadurch gekennzeichnet, daß die Leiterbahn (22) in eine der Anzahl der Spulen (111 bis 113) der Meßwicklung (11) entsprechende Zahl von jeweils elektrische Anschlüsse (24, 25) aufweisenden, voneinander elektrisch getrennten Leiterbahnabschnitten (221 bis 223) und/oder die den Sondenkern (10) umschließende elektrisch leitfähige Folie (27) in eine der Anzahl der Spulen (111 bis 113) der Meßwicklung (11) entsprechende Zahl von elektrisch voneinander getrennten, jeweils elektrische Anschlüsse (29) aufweisenden Folienabschnitten (271 bis 273) unterteilt ist und daß über die elektrischen Anschlüsse (24, 25; 29) unterschiedliche Spannungspotentiale an die Leiterbahnabschnitte (221 bis 223) und/oder die Folienabschnitte (271 bis 273) gelegt sind.

12. Sonde nach Anspruch 11, dadurch gekennzeichnet, daß die an den einzelnen Leiterbahnabschnitten (221 bis 223) und/oder Folienabschnitten (271 bis 273) liegenden Spannungspotentiale so bemessen sind, daß die resultierende Kapazität zwischen Sondenkern (10) und Meßwicklung (11) minimiert ist.

13. Sonde nach einem der Ansprüche 1 bis 12, dadurch gekennzeichnet, daß die Spulen (111 bis 113) der Meßwicklung (11) aus einem größeren Fertigungslos von Spulen in Hinblick auf größtmögliche Übereinstimmung mindestens einer ihrer Größen: Wicklungskapazität, Induktivität und Resonanzfrequenz ausgesucht und zur Meßwicklung (11) zusammengestellt sind.

14. Sonde nach einem der Ansprüche 1 bis 13, gekennzeichnet durch ein den Sondenkern (10) mit Meßwicklung (11) aufnehmendes Gehäuse (12) aus elektrisch leitfähigem Material.

15. Sonde nach Anspruch 14, dadurch gekennzeichnet, daß im Abstand um die Meßwicklung (11) herum eine aus einem elektrisch leitfähigen Blech oder einer elektrisch leitfähigen Folie bestehende umlaufende Potentialfläche (30) gelegt ist, die durch mindestens einen axialen Isolationssteg unterbrochen ist, und daß die Potentialfläche (30) elektrische Anschlüsse (31) zum Anlegen von Spannungspotentialen aufweist.

16. Sonde nach Anspruch 15, dadurch gekennzeichnet, daß die umlaufende Potentialfläche (30) parallel zur Wicklungsachse der Meßwicklung (11) geschlitzt ist.

17. Sonde nach Anspruch 15 oder 16, dadurch gekennzeichnet, daß die Potentialfläche (30) in eine der Anzahl der Spulen (111 bis 113) der Meßwicklung (11) entsprechende Zahl von ringförmigen Potentialflächenabschnitten (301 bis 303) unterteilt ist, die elektrisch voneinander getrennt sind und elektrische Anschlüsse (31) aufweisen.

18. Sonde nach Anspruch 17, dadurch gekennzeichnet, daß die Potentialflächenabschnitte (301 bis 303) mit den zugeordneten Leiterbahnabschnitten (221 bis 223) des Sondenkerns (10) elektrisch verbunden sind.

19. Sonde nach Anspruch 17, dadurch gekennzeichnet, daß die an den ringförmigen Potentialflächenabschnitten (301 bis 303) liegenden Spannungspotentiale so bemessen sind, daß die resultierende Kapazität zwischen Sondenkern (10) und Gehäuse (12) minimiert ist.

20. Sonde nach einem der Ansprüche 1 bis 19, dadurch gekennzeichnet, daß die Spulen (111 bis 113) der Meßwicklung (11) in Achsrichtung des Sondenkerns (10) nahezu abstandslos aneinanderliegen.

21. Sonde nach einem der Ansprüche 1 bis 20, dadurch gekennzeichnet, daß zwischen benachbarten Spulen (111, 112 bzw. 112, 113) der Meßwicklung (11) jeweils eine rechtwinklig zu den Spulenachsen sich erstreckende, ebene Potentialfläche (32 bzw. 34) angeordnet ist, die aus einem elektrisch leitfähigen Blech oder einer elektrisch leitfähigen Folie besteht und elektrische Anschlüsse (34) aufweist.

22. Sonde nach Anspruch 21, dadurch gekennzeichnet, daß die ebenen Potentialflächen (32, 33) elektrisch auf das gleiche Potential gelegt sind, wie die Leiterbahn (22) des Sondenkerns (19).

23. Sonde nach Anspruch 21, dadurch gekennzeichnet, daß die an den ebenen Potentialflächen (32, 33) liegenden Spannungspotentiale so bemessen sind, daß die resultierende Kapazität zwischen den Spulen (111 bis 113) minimiert ist.

24. Sonde nach Anspruch 11, 19 oder 23, dadurch gekennzeichnet, daß die unterschiedlichen Spannungspotentiale mittels eines Spannungsteilers (26) hergestellt sind, der vorzugsweise aus zwischen den elektrischen Anschlüssen (24, 25) eingeschalteten SMD-Widerständen (26) besteht.

25. Sonde nach einem der Ansprüche 1 bis 24, dadurch gekennzeichnet, daß im Gehäuse (12) zusätzlich ein mit der Meßwicklung (11) verbundener Anpaßverstärker (13) und eine Stromversorgungsquelle (14) integriert ist.
